# EUROPEAN PATENT APPLICATION

(11) **EP 1 900 857 A1**
(43) Date of publication of application: **19.03.2008**
(21) Application number: 07109755.4
(22) Date of filing: 06.06.2007
(51) Int. Cl.: C30B 25/18, C30B 29/40

(54) **Method of manufacturing single crystalline gallium nitride thick film**

(30) Priority: 14.09.2006 KR 20060089040
(71) Applicant: Samsung Corning Co., Ltd., Suwon-si, Gyeonggi-do 442-732 (KR)
(72) Inventor: Shin, Hyun Min, Jungnang-gu Seoul 131-814 (KR); Kong, Sun Hwan, Hwaseong-si Kyungki-do 445-983 (KR); Lee, Ki Soo, Jamwon-dong, Seocho-gu Seoul 137-797 (KR); Choi, Jun Sung, Jamwon-dong, Seocho-gu Seoul 137-797 (KR)
(74) Representative: Rupprecht, Kay

(57) **Abstract**

A method of manufacturing a single crystalline gallium nitride (GaN) thick film by using a hydride gas phase epitaxy (HVPE), more particularly, the method of manufacturing c-plane ({0001}) of a single crystalline GaN thick film by using the HVPE. A GaN film is grown on a substrate by providing a hydrogen chloride (HCl) gas and an ammonia (NH₃) gas, thereby obtaining the GaN film on the substrate, and a GaN thick film on the GaN film on the substrate is grown.

## Description

### [Brief Description of the Drawing]

FIG. 1 is a diagram illustrating a bending deformation which occurs in a GaN film on a sapphire substrate in a conventional art;
FIG. 2 is a diagram illustrating a crack which occurs in a GaN film on a sapphire substrate in a conventional art;
FIG. 3 is a diagram illustrating a crack-proof GaN thick film growth method in a conventional art;
FIG. 4 is a schematic view illustrating a manufacturing process of a GaN thick film using a method of artificially inducing a crack according to an embodiment of the present invention;
FIG. 5 is a photo micrograph illustrating a crack which is generated in a first GaN film according to an embodiment of the present invention;
FIG. 6 is a photo micrograph illustrating a crack which is generated in a GaN film on a sapphire substrate according to an embodiment of the present invention;
FIG. 7 is a photo micrograph illustrating a free-standing GaN thick film according to an embodiment of the present invention; and
FIG. 8 is a graph illustrating an analysis result of an X-Ray Diffraction (XRD) rocking curve of a GaN thick film according to an embodiment of the present invention.

### <Explanation of reference numerals for designating main components in the drawings>

- 11:: sapphire substrate
- 12:: GaN film
- 13:: crack
- 31:: GaN film
- 32:: GaN thick film
- 41:: first GaN film
- 42:: second GaN thick film

### [Detailed Explanation of the Invention]

### [Object of the Invention]

### [Technical Field of the Invention and Prior Art in the Field]

The present invention relates to a method of manufacturing a single crystalline gallium nitride (GaN) thick film for a semiconductor of high quality without bending deformation, and more particularly, to a method of manufacturing a c-plane ({0001}) of a single crystalline GaN thick film.

A single crystalline gallium nitride (GaN) film, which is used as a substrate when manufacturing a semiconductor element, is generally manufactured by using a vapor phase epitaxy such as hydride vapor phase epitaxy (HVPE) or metal organic chemical vapor deposition (MOCVD) on a substrate such as sapphire (α-Al₂O₃) or silicon carbide (SiC).

Sapphire is widely used as a substrate for manufacturing a GaN film. A lattice constant difference between the sapphire and a GaN is about 16%, and thermal expansion coefficient between the sapphire and the GaN is about 35%. Accordingly, when a GaN film grows on a sapphire substrate, a stress occurs on an interface. The stress generates a lattice defect, a bending deformation, and a crack in a GaN crystal, which may retard a growth of the GaN film, and may reduce a lifespan of an element manufactured on the GaN film.

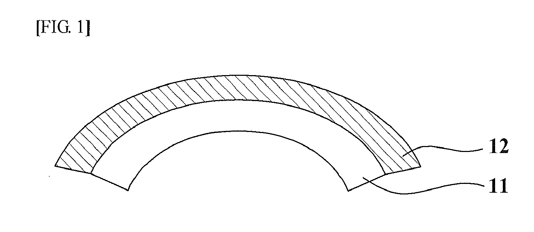

When a stress between sapphire and GaN is isotropic and the stress generated on a sapphire substrate 11 by a grown GaN film 12 is less than a yield point, the grown GaN film 12 bends towards a sapphire substrate 11 as shown in FIG. 1. As a thickness of the GaN film 12 increases, a radius of curvature decreases, and a bending deformation increases. The bending deformation causes a difference of crystalline property between a center portion and a periphery of the sapphire substrate 11 having a grown GaN thick film. Accordingly, when a light-emitting diode (LED) element is manufactured by using such a sapphire substrate, a light-emitting wavelength may not be uniform.

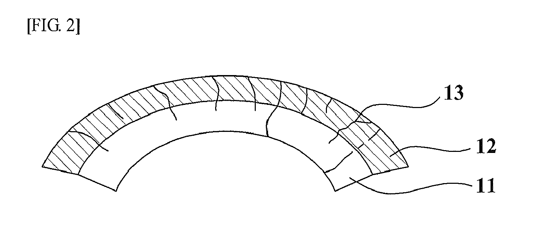

The bending deformation of a single crystalline GaN on the sapphire substrate is caused by the stress which is generated between the sapphire substrate and an interface of the GaN film. In order to reduce such stress, various interface state control methods, for example, "low temperature gallium nitride buffer epitaxy" disclosed in US Patent No. 5,290,393 (1994), "PENDEO epitaxy including artificial vesicle" disclosed in US Patent No. 6,177,688 (2001), "aluminum nitride (AIN) concave-convex shape epitaxy" disclosed in US Patent No. 6,528,394 B1 (2003), and 'Aluminum nitride (AIN) buffer epitaxy' disclosed in 'Applied physics letter' Vol. 56, p185, (1988) are used. However, the interface state control methods identified above are applicable, when a GaN film having a thickness of several µm to several tens of µm grows. Specifically, when the GaN film having the thickness of several hundreds of µm grows, a stress is not sufficiently relieved, and a crack occurs in the GaN film. Also, a stress generated in a sapphire substrate is greater than a yield point. Accordingly, a crack 13 occurs in the GaN film 12 on the sapphire substrate 11, as shown in FIG. 2. Thus, a thickness of the GaN film 12 has been required to be limited to less than several hundreds of µm.

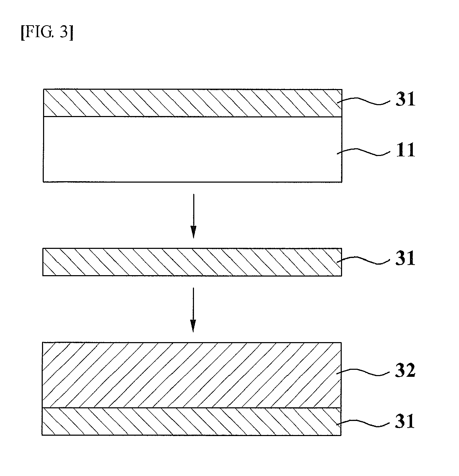

In order to overcome the disadvantages described above, the following method is generally used in a conventional art, as shown in FIG. 3. After growing a GaN film 31 having a thickness of several tens of µm to several hundreds of µm in order to prevent generation of a crack, the GaN film 31 is separated from a sapphire substrate 11, thereby eliminating stress. Then, a GaN thick film 32 is regrown on the separated GaN film 31. Such a method is disclosed in EP patent No. 01946718 and EP patent No. 01116827. However, the method is required to remove a hetero-substrate such as the sapphire substrate through a separation process using a laser or a mechanical polishing process, which is complex. Also, a tensile stress is applied to the separated GaN substrate for regrowing the GaN thick film 32 when growing the GaN film 31, and a compressive stress is applied when cooling. Accordingly, despite a growth method using an identical substrate, a bending deformation or a crack occurs in the regrown GaN thick film.

Also, another GaN film growth method is proposed in literature J. of Crystal growth, in press 2001. In the method, a crack is artificially induced on a surface of a GaN film by growing the GaN film having a thickness of several µm, in order to form a GaN film on a sapphire substrate without a crack. In this instance, silicon (Si) is doped to the sapphire substrate by the MOCVD, in the GaN film. Another GaN film is grown on the GaN film where the crack is artificially induced, and thereby forming the GaN film without the crack.

However, when using the MOCVD, a growth rate of the GaN film is several µm/h. Accordingly, growing a thick film having a thickness of several tens of µm to several hundreds of µm is difficult. In a structure where the silicon-doped GaN film having the thickness of several µm is grown, an interface stress difference is not so great that the crack may not be spread to the sapphire substrate. In this instance, the interface stress difference is induced by a difference between a thermal expansion coefficient and a lattice constant of the sapphire substrate and the GaN. Accordingly, an internal stress may not be relieved by completely spreading the crack to a bottom portion of the sapphire substrate. Thus, growing a GaN thick film having a thickness of greater than about 1 mm may not be available. Accordingly, a method of manufacturing a single crystalline GaN thick film for a quality semiconductor without bending deformation is required.

### [Subjects to be solved by this Invention]

The present invention provides a method of manufacturing a single crystalline GaN thick film which induces a sufficient amount of cracks in a single crystalline GaN film on a sapphire substrate, removes a stress, regrows a single crystalline GaN thick film on the single crystalline GaN film on the sapphire substrate, so that a single crystalline GaN thick film without a crack and a bending deformation may be easily obtained. Also, a process condition may be controlled, and thus a process of doping with silicon (Si) for inducing a crack may optionally be performed in the method of manufacturing a single crystalline GaN thick film.

### [Best Mode for Carrying Out the Invention]

To achieve above objectives and outperform the conventional art, according to an aspect of the present invention, there is provided a method of manufacturing a single crystalline gallium nitride (GaN) thick film by using a hydride gas phase epitaxy (HVPE), the method including: 1) obtaining a first GaN film having a crack, by providing a gallium source and mixed gas of hydrogen chloride (HCl) gas and nitrogen source gas in a HVPE reactor and growing the first GaN film on a substrate; 2) cooling the first GaN film on the substrate and spreading the crack to a bottom portion of the substrate; 3) growing a second GaN thick film on the first GaN film on the substrate; and 4) obtaining a freestanding GaN thick film by removing both the substrate where the crack is spread and the first GaN film, from the first GaN film/second GaN thick film on the substrate.

Reference will now be made in detail to embodiments of the present invention, examples of which are illustrated in the accompanying drawings, wherein like reference numerals refer to the like elements throughout. The embodiments are described below in order to explain the present invention by referring to the figures.

A method of manufacturing a single crystalline gallium nitride (GaN) thick film according to the present invention uses a hydride vapor phase epitaxy (HVPE). The HVPE provides a hydrogen chloride (HCl) gas and an ammonia (NH₃) gas in a volume ratio of about 1:2 to about 1:5. In this instance, the NH₃ gas is used as a nitrogen source of 5 V, and the HCl gas is used to generate a gallium chloride (GaCl) gas which is a gallium source of 3III. Also, in the HVPE, a crack is induced to a bottom portion of a substrate in an early stage of a GaN thick film growth, and subsequently the GaN thick film growth continues.

The method of manufacturing a single crystalline GaN thick film is suitable for growing a single crystalline GaN thick film of a c-plane ({0001}) on a (0001) plane of a sapphire substrate.

A growth rate of the HVPE which is used in the present invention is faster than a growth rate of a metal organic chemical vapor deposition (MOCVD). Accordingly, a GaN thick film having a thickness of several tens of µm to several hundreds of µm may be easily obtained. Also, the crack may be easily induced to a bottom portion of a sapphire substrate due to an increase in a stress which is caused by an increase in the thickness. Accordingly, a GaN thick film having a thickness greater than several hundreds of µm without a bending deformation may be grown.

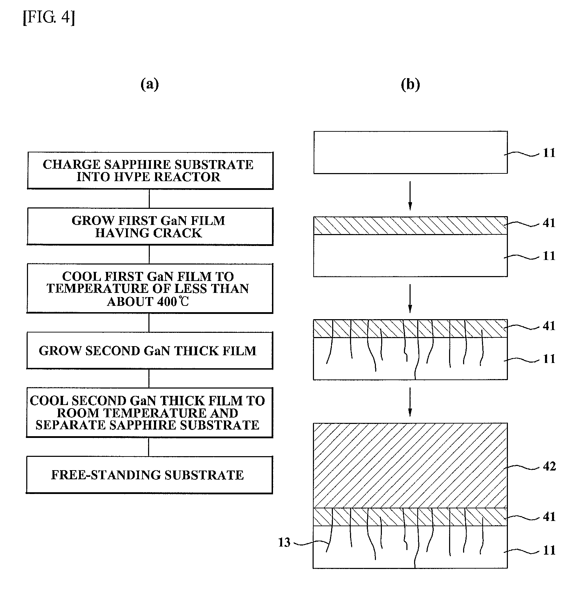

FIG. 4 is a schematic view illustrating a manufacturing process of a free-standing GaN thick film according to an embodiment of the present invention.

A sapphire substrate 11 is charged into a HVPE reactor, and a gallium (Ga) metal which is in a liquid or solid state is located in the HVPE reactor. In this instance, a temperature of about 600°C to about 900°C is required to be maintained. A HCl gas is provided in the HVPE reactor, and thereby generating a GaCl gas. Also, a NH₃ gas is provided through another inlet, and thereby causing a reaction between the GaCl gas and the NH₃ gas. Accordingly, a first GaN film 41 having a crack is grown on the sapphire substrate 11 at a temperature of about 930°C to about 1000°C. In this instance, the HCl gas and the NH₃ gas are provided in a volume ratio of about 1:2 to about 1:5. Also, in order to induce the crack, growing the first GaN film to have a thickness of about 50 µm to about 300 µm is preferable. When the thickness of the first GaN film is less than about 50 µm, the crack may not be easily generated. Also, growing the first GaN film to have a thickness of less than about 300 µm is preferable, since a GaN layer where the crack is spread is removed in a final manufacturing process. When a growth temperature is less than about 930°C while growing the first GaN film 41, a material diffusion on a growth surface is not properly performed, and a crystallinity is deteriorated. When the crystallinity is seriously deteriorated, a polycrystalline phase having a very rough surface is formed. When the growth temperature is greater than about 1000°C, a surface diffusion of an atomic source is smoothly performed on a GaN surface. Accordingly, a stable crystalline phase having a low energy is formed, and thus the crack which may relieve the stress may not be generated.

Also, an interface stress is removed by cooling the first GaN film on the sapphire substrate to a temperature of less than about 400°C, and spreading the crack to a bottom portion of the sapphire substrate 11.

Also, a second GaN thick film 42 is grown to have a desirable thickness on the GaN film on the sapphire substrate having the crack at the temperature of about 930°C to about 1100°C by using the Ga element (Ga source), the HCl gas and the NH₃ gas. Then, a free-standing GaN thick film without a bending deformation is manufactured by cooling the second GaN thick film 42 to a room temperature and separating the first GaN film 41 from the sapphire substrate 11 having the crack. In this instance, a general laser separation method is used when separating, and the separated first GaN film and sapphire substrate are separated in a particle form due to the crack. In this instance, each particle has an identical size of several hundreds of µm. When the growth temperature of the second GaN thick film 42 is not included in a range of the temperature of about 930°C to about 1100°C, an excellent crystallinity of a single crystalline GaN may not be acquired.

Optionally, in the present invention, in order to accelerate a crack inducement when growing the first GaN film 41, a silane (SiH₄) or a dichlorosilane (SiH₂Cl₂) is doped to the first GaN film 41 by a silicon (Si) concentration of less than about 2 x 10¹⁹ (atoms/cm³).

Particularly, in the present invention, it is preferable that the SiH₄ or the SiH₂Cl₂ is doped to the first GaN film 41 by a Si concentration of less than about 5 x 10¹⁸ (atoms/cm³). When excessively doping by the Si, a crystallinity of the second GaN thick film 42 may be deteriorated. Accordingly, excessively doping by the Si is not preferable in terms of a crystal growth.

Also, the method of manufacturing a single crystalline GaN thick film according to the present invention may be performed without doping by the Si, and a process of doping by the Si is an optional process for inducing the crack faster.

A single crystalline GaN thick film manufactured by the present invention has a diameter of greater than about 2 inches, more preferably a diameter of greater than about 4 inches. Also, the single crystalline GaN thick film manufactured by the present invention has a thickness of about 200 µm to about 1500 µm.

A tilt-angle towards a c-axis with respect to <0001> is measured by using a full width at half maximum (FWHM) of an X-Ray Diffraction (XRD) peak of a center of the single crystalline GaN thick film and an edge (002) which is spaced apart from the center. Also, the tilt-angle towards the c-axis with respect to <0001> is measured by using a movement of a central angle. In this instance, a degree of tilting of a crystal lattice due to the bending deformation may be measured. The smaller the tilt-angle is, the less the single crystalline GaN thick film bends.

According to the present invention, even when growing a GaN thick film having a thickness of greater than about 1 mm on the sapphire substrate 11, a free-standing GaN thick film having the tilt-angle towards the c-axis with respect to <0001> of less than about 0.0022 (°/mm) may be obtained. Also, the GaN thick film having the tilt-angle towards the c-axis with respect to <0001> of less than about 0.0022 (°/mm) may be obtained, when the GaN thick film has a equivalent direction of <0001> and an off-axis plane of less than about 7°. In this instance, the GaN thick film has a radius of curvature of greater than about 5 m.

Thus, the single crystalline GaN thick film according to the present invention is improved in terms of the thickness and the bending deformation, compared to a conventional GaN thick film, and thereby may be used as a semiconductor substrate.

Hereinafter, the present invention will be described in more detail through an embodiment of the present invention. Although one embodiment of the present invention is described, the present invention is not limited to the described embodiment.

### < Embodiment >

A sapphire substrate having a diameter of about 2 inches is charged into a HVPE reactor, and a first nitrification process is carried out by providing a NH₃ gas at a temperature of about 930°C to about 1000°C. A thermal process is performed by using a mixed gas of the NH₃ gas and an HCl gas, and a second nitrification process is carried out by providing the NH₃ gas. Then, a significant amount of gallium is loaded in a gallium container of the HVPE reactor, the HCl gas is provided in the HVPE reactor, and thereby generating a GaCl gas. In this instance, a temperature of about 600°C to about 900°C is required to be maintained. Also, the NH₃ gas is provided through another inlet, and thereby causing a reaction between the GaCl gas and the NH₃ gas. Accordingly, a first GaN film having a crack is grown to have a thickness of about 50 µm to about 100 µm. In this instance, the crack occurs around an interface between the sapphire substrate and the first GaN film. In this instance, the HCl gas and the NH₃ gas are provided in a volume ratio of about 1:2 to about 1:5, and a growth temperature is about 930°C to 1000°C. As a relative amount of the HCl with respect to the NH₃ gas increases and the growth temperature is low, more cracks and severe cracks occur.

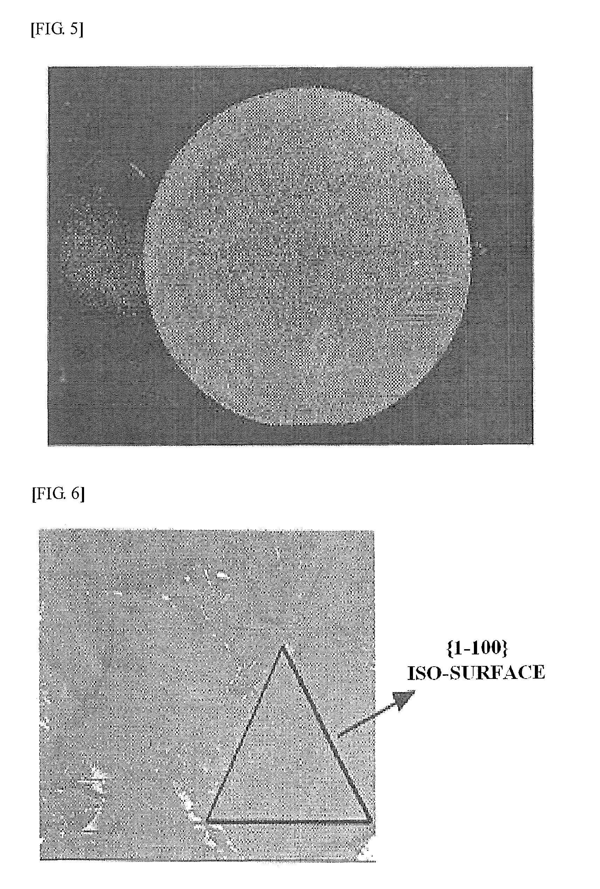

FIG 5 is a photo micrograph illustrating a crack which is generated in a first GaN film according to an embodiment of the present invention. In this instance, HCl gas and NH₃ gas are provided in a volume ratio of about 1:2. Through FIG. 5, it may be known that cracks showing a uniform distribution of cracks that are several tens of µm to several hundreds of µm are induced on a first GaN film, since a brittleness increases by excessively providing gas for occurring a gallium source of 3III, compared to when growing an existing GaN film. As shown in FIG. 6, the crack is formed along a cleavage {1-100} of the GaN, which shows that the crack occurs due to an initial growth condition on an interface.

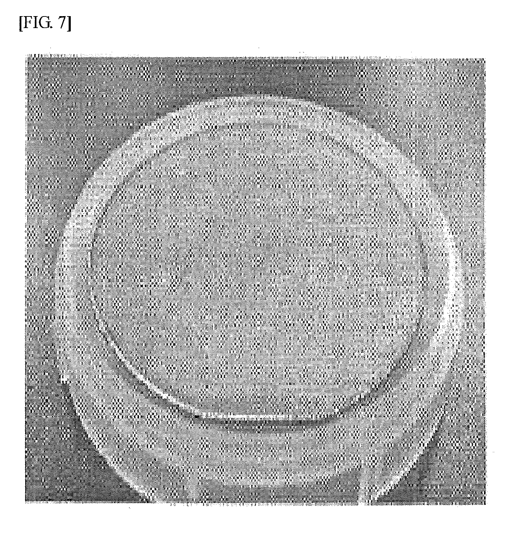

Also, the GaN film on the sapphire substrate is cooled to a temperature of about 400°C, and the crack is spread to a bottom portion of the sapphire substrate. Also, a HVPE is performed by sequentially using a Ga source, the NH₃ gas, and the HC1 gas, in a similar condition described above, and thereby growing a GaN thick film having a thickness of about 1 mm. From the GaN thick film, a free-standing single crystalline GaN thick film shown in FIG. 7 is obtained by separating a first GaN film, and a sapphire substrate having the crack from a second GaN thick film 42. In this instance, the free-standing single crystalline GaN thick film has a thickness of about 1 mm. When separating, an excimer laser (355 nm Nd:YAG laser) is used.

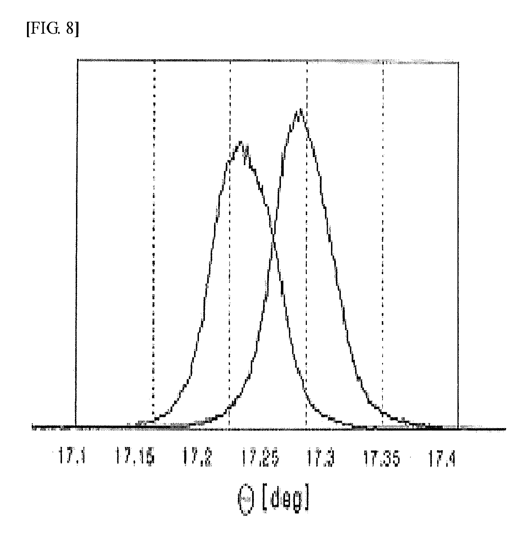

A full width at half maximum of an XRD peak of a center of the single crystalline GaN thick film and a portion which is spaced apart from the center by about 18 mm, and a peak center movement are analyzed. As a result of the analysis, as shown in FIG. 8, a tilt-angle of the portion which is spaced apart from the center by about 18 mm is about 0.040 (°/mm). Also, a tilt-angle towards a c-axis with respect to <0001> is 0.0022 (°/mm). Namely, the tilt-angle is much smaller than a tilt-angle of a conventional GaN thick film. Also, the GaN thick film has a radius of curvature of greater than about 5 m, which is much greater than a radius of curvature of the conventional GaN thick film, about 0.5 m. Accordingly, the GaN thick film according to the present invention may bend less, even though the GaN thick film is grown to have a thickness of about 1 mm which is approximately twice as thick as the existing GaN thick film having a thickness of up to about 400 µm. In this instance, an artificial crack inducement method is not applied to the conventional GaN thick film.

### [Advantageous Effects of the Invention]

According to the present invention, even when a GaN thick film having a thickness of about 1 mm which is even thicker than a conventional GaN thick film is grown, the GaN thick film having a radius of curvature of greater than about 5 m and with an insignificant bending deformation may be manufactured. Also, such a GaN thick film may be effectively used as a semiconductor substrate.

Although a few embodiments of the present invention have been shown and described, the present invention is not limited to the described embodiments. Instead, it would be appreciated by those skilled in the art that changes may be made to these embodiments without departing from the principles and spirit of the invention, the scope of which is defined by the claims and their equivalents.

## Claims

1. A method of manufacturing a single crystalline gallium nitride (GaN) thick film by using a hydride gas phase epitaxy (HVPE), the method comprising:
1) obtaining a first GaN film having a crack, by providing a gallium source and mixed gas of hydrogen chloride (HCl) gas and nitrogen source gas in a HVPE reactor and growing the first GaN film on a substrate;
2) cooling the first GaN film on the substrate and spreading the crack to a bottom portion of the substrate;
3) growing a second GaN thick film on the first GaN film on the substrate; and
4) obtaining a freestanding GaN thick film by removing both the substrate where the crack is spread and the first GaN film, from the first GaN film/second GaN thick film on the substrate.

2. The method of claim 1, wherein the HCl gas and the nitrogen source gas have a volume ratio of about 1:2 to about 1:5 in the mixed gas of HCl gas and nitrogen source gas.

3. The method of claim 1, wherein the substrate comprises a single crystalline sapphire substrate.

4. The method of claim 3, wherein the first GaN film and the second GaN thick film is grown on a c-plane ({0001}) of the substrate.

5. The method of claim 4, wherein the first GaN film and the second GaN thick film is grown through the c-plane ({0001}).

6. The method of claim 1, wherein the first GaN film is grown to have a thickness of about 50 µm to about 300 µm.

7. The method of claim 1, wherein the first GaN film is grown at a temperature of about 930°C to about 1000°C by the HVPE.

8. The method of claim 1, wherein the first GaN film on the substrate is cooled to a temperature of less than about 400 °C.

9. The method of claim 1, further comprising:
doping the first GaN film by using any one of a silane (SiH₄) and a dichlorosilane (SiH₂Cl₂) when growing the first GaN film.

10. The method of claim 9, wherein any one of the SiH₄ and the SiH₂Cl₂ is doped to the first GaN film at a concentration of less than about 2 x 10¹⁹ (atoms/cm³).

11. The method of claim 10, wherein any one of the SiH₄ and the SiH₂Cl₂ is doped to the first GaN film at a concentration of less than about 5 x 10¹⁸ (atoms/cm³).

12. The method of claim 1, wherein the second GaN thick film is grown by the HVPE at a temperature of about 930 °C to about 1100 °C.

13. A single crystalline GaN thick film having an off-angle (a tilt-angle) towards a c-axis with respect to a-direction (<0001>) of less than about 0.0022 (°/mm), a diameter greater than about 2 inches, and a thickness of about 200 µm to about 1500 µm, and being manufactured by any one method of claims 1 through 13.

14. The single crystalline GaN thick film of claim 13, a crystalline surface of the GaN thick film is a c-plane ({0001}).

15. A semiconductor element comprising the single crystalline GaN thick film according to any one of claims 13 and 14.
